# EUROPÄISCHE PATENTSCHRIFT

(11) **EP 1 557 396 B1**
(45) Veröffentlichungstag und Bekanntmachung des Hinweises auf die Patenterteilung: **31.08.2016**
(21) Anmeldenummer: 04027826.9
(22) Anmeldetag: 24.11.2004
(51) Int. Cl.: B81C 99/00

(54) **Verfahren zur Herstellung von Mikroröhrchen aus Polymermaterialien**
Method of manufacture of microtubes of polymeric material
Méthode de fabrication de microtubes de materiau polymerique

(30) Priorität: 21.01.2004 DE 102004004262
(43) Veröffentlichungstag der Anmeldung: 27.07.2005
(73) Patentinhaber: Leibniz-Institut für Polymerforschung Dresden e.V., 01069 Dresden (DE)
(72) Erfinder: Loutchnikov, Valery, Dr., 01069 Dresden (DE); Sydorenko, Olexandr, Dr., 01159 Dresden (DE); Stamm, Manfred, Prof. Dr., 01705 Freital-Pesterwitz (DE)
(74) Vertreter: Sperling, Thomas

(56) Entgegenhaltungen:
- DE-A1- 10 159 415
- DE-T2- 68 927 756
- ANNE DE ROVKRE ET AL: "Melt-Spun Hollow Fibers: Modeling and Experiments", POLYMER ENGINEERING & SCIENCE, Bd. 41, Nr. 7, 1. Juli 2001 (2001-07-01), Seiten 1206-1219, XP055187440, DOI: 10.1002/pen.10822

## Beschreibung

Die Erfindung betrifft ein Verfahren zur Herstellung von Mikroröhrchen aus Polymermaterialien.

Mikroröhrchen sind im Stand der Technik bekannt und werden auch als Microtubes oder Nanotubes bezeichnet, je nach Dimension von Durchmesser und Länge. Bislang wurden Mikroröhrchen als Konstruktionselemente in Mikrofluidvorrichtungen, wie Mikrokanälen, Mikropumpen, Mikrocontainem und Mikroreaktoren sowie als Mikroaktuatoren für das Design von selbst organisierenden Strukturen und in Mikrorobotern, verwendet.

Weiterhin sind Mikroröhrchen aus Polymermaterialien für den Einsatz in der biomedizinischen Forschung bekannt. Derartige Mikroröhrchen zeichnen sich aufgrund der Polymereigenschaften und der möglichen Funktionalisierung der Polymeroberflächen durch eine Kompatibilität mit biochemischen Stoffsystemen und lebenden Zellen aus.

Die bekannten Mikroröhrchen auf der Basis von Polymermaterialien können auch als Template für die Fabrikation von Microwaveguides und Nanokabeln nach einer Metallisierung verwendet werden. Unter einem Nanokabel bzw. Nanowire wird ein rohr- bzw. strangförmiger Gegenstand in der Dimension von Mikroröhrchen verstanden, welcher eine elektrische Leitfähigkeit besitzt.

Im Stand der Technik sind verschiedenen Verfahrensweisen zur Herstellung von Mikroröhrchen mit einem inneren Durchmesser von wenigen Mikrometern oder kleiner und einem großen Verhältnis von Länge zu Durchmesser des Mikroröhrchens bekannt.

Aus der DE 101 59 415 A1 ist bereits ein Verfahren bekannt, Mikroröhrchen durch Aufrollen von Halbleitermaterialien herzustellen, wodurch mikro- und nanoskopische Spulen, Transformatoren und Kondensatoren durch Einrollen oder Umklappen von Leiterschichten beim Ablösen von Hilfsschichten von einem Substrat erzeugt werden können.

Weiterhin geht aus Prinz et al.: "Precise micro- and nanotubes formed by scrolling Langmuir-Blodgett/GaAs films" 8th Int. Symp. Nanostructures: Physics and Technology, St. Petersburg, Russia, June 19-23, 2000, 6 Seiten hervor, dass zusätzlich zu Halbleiterschichten Langmuir-Blodgett-Schichten eingerollt werden können.

Aus Sahoo et al.: "Actuators based on electroactive polymers" in Current Science, Vol. 81, Nr. 7, 2001, S. 743-746 ist ein Verfahren bekannt, in einem Polymer-Metall-Schichtsystem ein Biegemoment durch eine Volumenänderung der Polymerschicht zu erzeugen, wobei jedoch keine Mikroröhrchen hergestellt werden.

Bei der Soft-Lithography wird ein Kanal durch Ätzung geformt. Zunächst wird dazu ein Strang oder Draht aus ätzbarem Material durch microprinting geformt, dann wird dieser Draht von einem nicht ätzbaren Material umhüllt und schließlich wird der Kanal durch das selektive Entfernen bzw. Ätzen des Drahtes geformt. Auf diesem Wege sind Mikrokanäle mit Durchmessern im Submikronbereich produzierbar.
Diese Technologie erlaubt die Herstellung von Kanälen mit komplizierteren geometrischen Strukturen. So ist die Soft-Lithography momentan das bevorzugte Verfahren zur Herstellung von Mikrofluidvorrichtungen.
Diesem Verfahren haftet jedoch der Nachteil an, dass die elastomeren Stamps deformierbar sind und in organischen Lösungsmitteln schwellen.

Daraus ergibt sich eine Begrenzung der Auflösung des microprint-Verfahrens und dadurch bedingt der durch Soft-Lithografphy erzeugbaren Mikroröhrchen. Ein anderer Nachteil besteht in der Schwierigkeit der Produktion von nichtplanaren Systemen, von Kanälen oder von freistehenden Röhrchen, welche teilweise oder vollständig vom Substrat getrennt sind.

Ein weiteres im Stand der Technik bekanntes Verfahren ist die Produktion von organischen Micro- und Nanotubes durch elektrochemische Synthese. Dabei werden geätzte Poren in Membranen als Template benutzt. Mittels dieses Verfahrens sind zylindrische Polymertubolis mit einem Außendurchmesser von 20 Nanometern bis 20 Mikrometern und mit einer Länge von 20 Mikrometern bis zu einigen Zentimetern erhältlich.
Dieser Verfahrensansatz erlaubt die Produktion von polymeren Mikroröhrchen in großen Mengen, jedoch ist die Konstruktion von komplexen Mikrofluidvorrichtungen mit diesem Verfahren weiterhin sehr problematisch.

Weiterhin sind im Stand der Technik Verfahren für die Herstellung von freistehenden oder fixierten mikro- und nanoskalierten Objekten, einschließlich Mikroröhrchen, bekannt, die auf dem Self-Scrolling-Effekt beruhen.

Der Self-Scrolling-Effekt besteht darin, dass in analoger Weise zu einem Bimetall durch physikalische oder physikalisch-chemische Eigenschaften verschiedener, miteinander mechanisch oder in sonstiger Weise miteinander gekoppelter Materialien durch Ausdehnung oder Schrumpfung bzw. Zusammenziehen eines der verwendeten flächigen Materialien ein Biegemoment entsteht. Das Biegemoment hat zur Folge, dass sich das flächige System zusammenrollt.
Bei diesem Verfahren werden auf einem festen Substrat eine Opferschicht und auf dieser mindestens zwei Schichten, ein sogenannter Bilayer, aufgebracht, wobei eine Schicht des Bilayers unter einer Vorspannung steht. Anfangs ist der Bilayer mit der Opferschicht durch beispielsweise molekulare Kräfte verbunden.

Die der Opferschicht zugewandte untere Komponente des Bilayers ist gespannt, und die obere Komponente ist komprimiert bzw. gequetscht.
Die Kräfte innerhalb des Bilayers erzeugen das Biegemoment, welches zum Aufrollen des Bilayers führt, nachdem dieser vom Substrat bzw. von der Opferschicht gelöst wird. Die Volumen- bzw. Längenänderung der Komponenten des Bilayers erzeugen das Biegemoment, wobei die Ursachen für die Volumenänderung verschiedener Natur sein können.
Der Self-Scrolling-Effekt ist für bimetallische Filme bzw. Lagen bekannt. Das Biegemoment in diesem System wird verursacht durch ungleiche Koeffizienten der thermischen Ausdehnung von Metallen im Bilayer.

Der Self-Scrolling-Effekt wurde bereits im Stand der Technik für die Herstellung von Mikroröhrchen aus Monokristallfilmen von Halbleitermaterialien genutzt, wobei diese Materialien durch "molecular beam epitaxy" erzeugt wurden. Die Schichten des Bilayers werden dabei kovalent aneinander gebunden, wodurch sich das Gleichgewichtskristallgitter für die obere Lage und die untere Lage leicht verändert. Anfangs wird der gespannte Bilayer von der Opferschicht durch molekulare Kräfte gehalten. Nach der Ablösung vom Substrat durch selektives Ätzen des Opferlayers faltet sich der Bilayer zu einem Mehrwandröhrchen. Die Dicke der Röhrchen kann präzise kontrolliert werden durch die Dicke der einzelnen Schichten und Lagen und reicht von einigen Nanometern bis zu mehreren Mikrometern. Die auf diese Weise erzeugten Halbleiter-Mikroröhrchen weisen bemerkenswerte mechanische und elektrische Eigenschaften auf.
Der Nachteil der Mikroröhrchen nach dem Self-Scrolling-Effekt besteht jedoch darin, dass nur metallische oder Halbleiter-Mikroröhrchen durch die im Stand der Technik bekannten Verfahren erhältlich sind.

Der Effekt der Biegung von gespannten Bilayern eignet sich auch für den Einsatz von Mikroaktuatoren. Diese Geräte nutzen die Eigenschaft von miteinander verbundenen Polymeren, ihr spezifisches Volumen während elektro-chemischer Reduktion oder Oxidation in Elektrolyten zu ändern. Der typische Volumenänderungseffekt tritt bei Polymeren, wie Polypyrrol, Polyanilin, und Polythiophen, auf.

Die Änderung des Volumens wird verursacht durch das Anlegen eines elektrischen Potenzials, Altersprozesse sowie durch Oxidation und Reduktion der Polymere. Die Verwendung von Polymeren-Elektrolyt-Sandwiches zwischen den verbundenen Polymerlayern erlaubt die Operation von Mikroaktuatoren in einer normalen Umgebung anstelle eines flüssigen Elektrolyts. Nach diesem Verfahren wurden Aktuatoren von 10 Mikrometer und 40 Mikrometern Größe aus Polypyrrol als Aktivlayer hergestellt.

Es besteht somit ein großes Interesse von Forschung und Industrie, das Verfahren zur Herstellung von Mikrokanälen zu vereinfachen und dabei kostengünstig auch geometrisch anspruchsvolle Strukturen bzw. Ausgestaltungen von Mikroröhrchen bzw. Mikrokanälen zu erzeugen.

Der Erfindung liegt die Aufgabe zugrunde, ein Verfahren für die Herstellung von Mikroröhrchen kostengünstig und effizient zur Verfügung zu stellen.
Die Aufgabe der Erfindung wird durch ein Verfahren zur Herstellung von Mikroröhrchen aus Polymermaterialien gelöst, bei dem
a) auf einem festen Substrat mit einer ebenen Oberfläche eine erste dünne Schicht eines Polymers aufgebracht wird,
b) wonach mindestens eine zweite Schicht auf der ersten Schicht aufgebracht wird, wonach
c) die mehrlagige Polymerschicht auf dem Substrat in Segmente derart zertrennt wird,
d) dass anschließend ein Lösungsmittel entlang der Außenkanten der Segmente zum Substrat vordringen kann und die mehrlagige Polymerschicht segmentweise vom Substrat abgelöst wird, wobei
e) das Lösungsmittel aus Verfahrensschritt e) eine Volumenänderung in mindestens einer Schicht hervorruft, so dass
f) die vom Substrat abgelösten Segmente der mehrlagigen Polymerschicht sich zu Mikroröhrchen rollen.

Alternativ wird die Aufgabe der Erfindung dadurch gelöst, dass
A) auf einem festen Substrat mit einer ebenen Oberfläche eine Schicht eines Polymers aufgebracht wird,
B) wobei die Polymerschicht einen Gradienten in Richtung der Schichtdicke aufweist und der Gradient eine physikalisch-chemische oder chemische Eigenschaft des Polymers betrifft, die eine Volumenänderung verursachen kann und dass
C) die einlagige Polymerschicht auf dem Substrat in Segmente derart zertrennt wird,
D) dass anschließend Lösungsmittel entlang der Außenkanten der Segmente zum Substrat vordringen kann und die einlagige Polymerschicht segmentweise vom Substrat abgelöst wird, wobei
E) das Lösungsmittel aus Verfahrensschritt E) in mindestens einer Gradientenschicht der Polymerschicht zu einer unterschiedlichen Volumenänderung führt, so dass
F) die vom Substrat abgelösten Segmente der einlagigen Polymerschicht sich zu Mikroröhrchen rollen.

Besonders vorteilhaft an dem erfindungsgemäßen Verfahren ist, dass durch den Einsatz von Polymermaterialien die Mikroröhrchen im Gegensatz zu metallischen oder Halbleiter-Mikroröhrchen biokompatibel ausbildbar sind. Dies erlaubt die Verwendung in biochemischer und biomedizinischer Forschung. Die Wände der polymeren Mikroröhrchen können funktionalisiert werden mit verschiedenen biologisch aktiven Gruppen.
Eine große Gruppe von Polymeren, nicht nur konjugierte Polymere, können verwendet werden, was zu einer großen Anwendbarkeit der Erfindung auf dem Gebiet der polymeren Mikroröhrchen führt.
Die Anwendungsgebiete der erfindungsgemäßen Mikroröhrchen sind sehr vielfältig.
Die polymeren nach dem Self-Scrolling-Effekt erzeugten Mikroröhrchen sind beispielsweise bevorzugt geeignet für die Verpackung von Mikro- und Nanoobjekten. Die Nano-Verpackung wird angewendet für kolloidale Partikel, lebende Zellen, Viren, Proteine und Polypeptide, DNA-Einzelmoleküle, Nanofäden, Nanocluster von Metallen und Halbleitern sowie Fluoreszenzmarkern und Kombinationen von vorgenannten Anwendungsobjekten.
Beispielsweise können mit Hilfe der erfindungsgemäßen Mikroröhrchen Bündel von Nanofäden für Nanosolenoide bzw. Nanospulen für mikroelektronische Geräte erzeugt werden.
Weiterhin kann mit Hilfe der Mikroröhrchen die kontrollierte Diffusion von Produkten des Stoffwechsels von in den Mikroröhrchen eingeschlossen lebenden Zellen bewirkt werden.
Gleichfalls können hochselektive Biosensoren mittels der erfindungsgemäßen Mikroröhrchen erzeugt werden durch die gezielte Anordnung von Proteinen und DNA-Strängen in Mikroröhrchen.

Die Konzeption der Erfindung besteht darin, dass der Self-Scrolling-Effekt auf mehrlagige Polymerschichten und auf einlagige Polymerschichten mit Gradientenschichten angewendet wird. Die mehrlagige Polymerschicht kann dabei aus mindestens zwei oder auch aus drei oder weiteren Schichten aufgebaut sein. Als Gradientenschicht wird eine Schicht in einer Polymerschicht verstanden, die innerhalb der Gradientenschicht eine homogene aber in Richtung der Schichtdicke der Polymerschicht abweichende physikalisch-chemische oder chemische Eigenschaften aufweist.

Konzeptionsgemäß ist eine Volumenausdehnung und/oder eine Volumenverringerung in einer von der mittleren Lage abweichenden Schicht oder der äußeren Schichten der mehrlagigen Polymerschicht oder in einer Gradientenschicht der einlagigen Polymerschicht auszulösen, um ein Biegemoment zu erzeugen und den Self-Scrolling-Effekt zu verwirklichen.

Das Lösungsmittel oder eine Komponente des Lösungsmittels in Verfahrensschritt d) oder D) wird dabei gemäß einer vorteilhaften Ausgestaltung der Erfindung derart gewählt, dass eine chemische Umsetzung einer Lage oder Komponente der Polymerschicht stattfindet, wobei die Umsetzung eine Volumenänderung zur Folge hat. Die Umsetzung oder Zersetzung eines Teils einer Lage, abweichend von einer mittleren Lage der Polymerschicht oder der Oberfläche, führt zum gewünschten Self-Scrolling-Effekt. Als Lösungsmittel werden in Abhängigkeit der stofflichen Beschaffenheit der Polymerschicht oder Lagen sowie der Substrate oder Opferschicht je nach Anwendungsfall auch Mischungen von Lösungsmitteln im weiteren Sinne verstanden. Dies beinhaltet organische und anorganische Lösungsmittel im engeren Sinne sowie Säuren, Basen, Wasser, wässrige Lösungen und sonstige Fluide.

Als signifikante Vorteile der Erfindung sind zu nennen:
- Durch die Variabilität von Polymermaterialien lassen sich diese besonders vorteilhaft als Konstruktionsmaterialien für Mikrofluidvorrichtungen einsetzen.
- Die Polymerfilme bzw. -lagen, -schichten oder -layer können durch Verfahren mit niedrigen Kosten, wie beispielsweise Imprinting, ausgeführt werden; gleichfalls ist die Herstellung von dünnen Polymerfilmen durch Spin-Coating oder Tauchbeschichtung möglich, wobei diese Beschichtungsverfahren sehr viel preiswerter und besser verfügbar sind als das Verfahren der "molecular beam epitaxy", welches für die Herstellung von Metall oder Halbleitermetallfilmen erforderlich ist.
- Die Oberflächen der erfindungsgemäß erhältlichen Kanäle oder Mikroröhrchen aus Polymeren können biologisch oder chemisch funktionalisiert werden und sind somit an spezielle Einsatzgebiete anpassbar, auf diesem Wege ist beispielsweise eine Biokompatibilität erreichbar, was sehr wesentlich für Experimente mit Biomolekülen und lebenden Zellen ist.
- Polymerbasierte Mikroröhrchen und die daraus erzeugbaren Produkte, wie Mikroreaktoren, sind kostengünstig herstellbar und außerdem teilweise sogar biologisch abbaubar und können ökologisch sinnvoll somit auch in größeren Mengen für die DNA-Analyse und die Zellkultur verwendet werden.
- Im Gegensatz zu aus Metallen oder Halbleitern erzeugten Mikroröhrchen, sind die aus Polymeren erzeugbaren Mikroröhrchen elastisch und können schwellen, wodurch Polymerfilme verschiedener Größe und Dicke und damit Mikroröhrchen verschiedener Ausmaße herstellbar sind; dies ermöglicht die Herstellung von sehr speziellen Geometrien; es wird die Herstellung von Mikroröhrchen mit Durchmessern im Mikrometer- und Submikrometerbereich und unterschiedlicher Filmdicke sowie verschiedenen mechanischen Eigenschaften möglich.
- Ein weiterer zu nennender Vorteil ist, dass eine große Breite von Polymeren verwendbar ist durch die häufig anzutreffende Eigenschaft der Polymere durch Aufnahme von Lösungsmitteln zu schwellen und damit ein Biegemoment in einer mehrlagigen Polymerschicht zu erzeugen.
- Herstellungstechnisch ist hervorzuheben, dass die Faltrate präzise kontrolliert werden kann durch selektives Ätzen.
- Die Faltrichtung ist ebenfalls durch die Kombination des Beschichtungssystems und der verwendeten Lösungsmittel im Vorhinein präzise bestimmbar; dies ermöglicht die Herstellung von individuellen Polymer-Mikroröhrchen.

Die Erfindung wird besonders vorteilhaft ausgeführt, wenn vernetzbare Polymere nach Verfahrensschritt a) und/oder nach Verfahrensschritt b) eingesetzt und vernetzt werden. Dies erhöht die Stabilität der einzelnen Polymerlagen.

Die Vernetzung selbst ist in Abhängigkeit des eingesetzten Polymers beispielsweise durch eine Bestrahlung mit ultraviolettem Licht oder auch chemisch möglich und in vielfältiger Weise bereits im Stand der Technik bekannt.

Besonders vorteilhaft werden die Polymerlagen in Verfahrensschritt a), A) und/oder b) durch eine Tauchbeschichtung oder Spin-Coating auf das Substrat bzw. aufeinander aufgebracht.
Als Substrat wird nach einer Ausgestaltung der Erfindung ein Silizium-Wafer eingesetzt. Besonders vorteilhaft ist es, auf dem Wafer eine Opferschicht aus Metall oder Oxid aufzubringen, welche vom Lösungsmittel in Verfahrensschritt d) oder D) aufgelöst wird. Als Opferschicht findet bevorzugt eine Schicht aus Aluminium, Titan oder Siliciumoxid Anwendung. Die Metallschicht wird durch Sputtern oder elektro-chemischem Auftrag auf dem Wafer oder auch einem anderen geeigneten Substrat aufgebracht.

Gleichfalls vorteilhaft ausgeführt wird die Erfindung, wenn als Substrat von vornherein ein Metall eingesetzt wird.
Weitere Ausgestaltungen der Erfindung liegen im Einsatz von Halbleitern, Glas, Polymeren, Fetten, Keramik, Biopolymeren, Ionenkristallen, absorbierte Schichten von Kohlendioxid, Polymerbündel und quasi-Flüssigschichten als Substrat.

Nach einer weiteren Ausgestaltung der Erfindung mit mehrlagiger Polymerschicht wird die Verbindung der unterschiedlichen Schichten oder Lagen untereinander durch einen Bindungsvermittler verstärkt. Damit wird der Zusammenhalt der einzelnen Lagen der mehrlagigen Polymerschicht erreicht oder verstärkt und die unerwünschte Ablösung der einzelnen Lagen voneinander weitgehend verhindert.
Als Bindungsvermittler wird nach einer Ausgestaltung der Erfindung ein Blockcopolymer vorgesehen, welcher Elemente der beiden Schichten enthält. Weitere vorteilhaft einsetzbare Bindungsvermittler sind Silane, Thiophene und Phosphazene.

Die einzelnen Segmente der mehrlagigen Polymerschicht in Verfahrensschritt c) oder C) werden bevorzugt durch eine Kratztechnik erzeugt. Alternativ dazu ist eine Schneid- oder Ritztechnik gleichfalls vorteilhaft einsetzbar, um die Segmente in die entsprechende gewünschte geometrische Form zu bringen, die sich anschließend durch den Self-Scrolling-Effekt zusammenrollen und dadurch Mikroröhrchen bilden.
Gleichfalls sind zur Erzeugung der Segmente lithografische Verfahren, wie z.B. Photolithografie, Elektronenstrahllithografie, Nanolithografie, dip-pen-Lithografie oder Imprinting-Verfahren, anwendbar.

Für die Erzeugung besonders langer Mikroröhrchen ist die Erzeugung von streifenförmigen Segmenten vorteilhaft. Das eingesetzte Lösungsmittel für das Ablösen der Segmente vom Substrat bzw. zum Auflösen der Opferschicht ist nach einer vorteilhaften Ausgestaltung der Erfindung geeignet, die Volumenausdehnung in der Lage der Polymerschicht zu bewirken.

Alternativ enthält das Lösungsmittel eine separate Komponente zur Bewirkung der erfindungsgemäßen Volumenänderung einer Lage der Polymerschicht.

Nach einer bevorzugten Ausgestaltung der Erfindung wird ein festes flaches Substrat mit einer ausreichend glatten Oberfläche, wie sie zum Beispiel ein Silicium-Wafer aufweist, verwendet.
Eine Opferschicht wird auf dieser Oberfläche aufgebracht. Als Opferschicht wird eine relativ dünne, beispielsweise eine Submikronschicht eines Metalls oder eines Oxids, wie Aluminium, Titan oder Siliciumoxid, durch Sputtern oder elektro-chemischen Auftrag aufgebracht.

Ein dünner Film eines vernetzbaren oder quervernetzbaren Polymers wird nunmehr auf dem Substrat durch Tauchbeschichtung oder Spin-Coting aus einer Lösung aufgetragen.
Die erste Schicht wird nunmehr durch UV-Bestrahlung oder chemisch vernetzt, was gewöhnlich die Robustheit der Schicht deutlich erhöht.
Die zweite Schicht eines anderen Polymers wird auf der ersten Schicht durch Tauchbeschichtung oder Spin-Coting wiederum aus einer Lösung aufgebracht. Das Lösungsmittel für das Polymer der zweiten Schicht sollte das Polymer der ersten Schicht nicht oder nur sehr schlecht lösen, um eine Ablösung der ersten Schicht vom Substrat zu verhindern. Nunmehr wird zur Verbesserung der Bindung zwischen der ersten und der zweiten Schicht ein Bindungsvermittler aufgebracht, beispielsweise ein Blockcopolymer.
Die zweite Schicht wird, wenn erforderlich, nunmehr gleichfalls quervernetzt.

Durch eine Kratztechnik wird auf dem beschichteten Wafer nun die gewünschte Geometrie der einzelnen Segmente erzeugt. Entlang der Kratzer dringt ein Lösungsmittel zur Opferschicht vor, woraufhin sich diese Opferschicht auflöst und sich die mehrlagige Polymerschicht segmentweise vom Substrat ablöst. Die mehrlagige Polymerschicht wird nunmehr in dem Lösungsmittel oder einer weiteren Lösung, welche selektiv ein Polymer quellen lässt, eingebracht. Die Ausprägung des Rolleffektes der mehrlagigen Polymerschicht kann durch die Konzentration des Lösungsmittels kontrolliert werden. Zu schnelles Ablösen der Segmente sollte vermieden werden, da ausreichend Zeit für den Rolleffekt gegeben werden muss. Als Lösungsmittel sind auch Mischungen von verschiedenen Lösungsmitteln geeignet, wodurch eine exakte Einstellung der gewünschten Ablösezeit und Eigenschaften der Mikroröhrchen möglich wird. Die gerollte mehrlagige Polymerschicht formt ein stabiles Mikroröhrchen. Soweit erforderlich, kann das Mikroröhrchen stabilisiert werden durch ein Verschmelzen der Schichten oder Kanten.

Das erfindungsgemäße Verfahren wird angewendet für die Fabrikation von Mikroröhrchen von verschiedenem Durchmesser und verschiedener Länge, wobei gleichfalls die Wanddicke und im weiteren Sinne die mechanischen Eigenschaften durch das verwendete Lösungsmittel und Schwellungsmittel sowie die verwendeten Polymere selbst als auch die Bindungsvermittler und die Vernetzung anpassbar sind.

Eine erfindungsgemäße Ausgestaltung wird anhand des folgenden Beispiels erörtert. Die Prozentangaben im Ausführungsbeispiel sind Masseprozent.
Eine 10 µm dicke Aluminiumfolie wird mit Poly-(4-Vinylpiridin) (P4VP, Molekulargewicht Mw=42500 g/mol) mittels Tauchbeschichtung beschichtet, wobei das P4VP als eine 5 prozentige Lösung des Polymers in Chloroform eingesetzt wird.
Die Aluminiumfolie ist in dieser Ausgestaltung der Erfindung Substrat und Opferschicht zugleich.
Die P4VP Schicht wird durch eine Quaternisierungsreaktion quervernetzt in gesättigtem Dampf von 1,4-Diiodbutan.
Dann wird eine Polystyrene-Schicht (PS, M_{W}=48400 g/mol) über der P4VP-Schicht mittels eines dip-coating-Verfahrens aufgebracht. Dabei wird das PS in einer 5 prozentigen Lösung in Toluen angewandt.
Es ist anzumerken, dass konzeptionsgemäß das Toluen kein Lösungsmittel für P4VP ist.

Mit einer geringen Menge eines Bindungsvermittlers wird der Zusammenhalt der Schichten aus P4VP und PS erhöht.
Als Bindungsvermittler wird PS-P4VP Block-Copolymer (M_{W} PS 32900 g/mol; PVP 8080 g/mol) eingesetzt. Der Bindungsvermittler wird der PS-Lösung in einer Menge von 1 % bezogen auf die Menge PS zugegeben.
Die entstandene mehrlagige Polymerschicht wird auch als Mikrokomposit-Bilayer bezeichnet und hat eine Dicke von ca. 0,5 µm, was über Messungen mittels eines atomic-force-microscop (AFM) festgestellt wurde.

Die mehrlagige Polymerschicht wird in eine einprozentige Salzsäure (HCl) gegeben. Die PS-Schicht zieht sich zusammen und wirkt als Schutzschicht für die P4VP-Schicht und das Aluminiumsubstrat. Um den Zutritt der Säure zu der inneren Lage zu ermöglichen wird mittels Kratztechnik der Bilayer zerschnitten. Die saure Lösung ist ein gutes Lösungsmittel für P4VP und gleichzeitig löst sie die Aluminiumfolie auf, welche als Opferschicht und starres Substrat dient. Die P4VP-Schicht schwillt unter dem Einfluss der Salzsäurelösung und dehnt sich aus. Die Ausdehnung wird begrenzt durch die starre PS-Schicht, was zu einem ausreichenden Biegemoment und zum Einrollen der mehrlagigen Polymerschicht führt. Bereits nach einigen Minuten sind Mikroröhrchen mit einem Durchmesser von ca. 5 µm mit diesem Verfahren erhältlich. Die durchschnittliche Länge der Mikroröhrchen beträgt ca. 3 mm und das Längen (L) /Durchmesser (D) -verhältnis beträgt somit L/D~600.

Konzeptionsgemäß sind verschiedene Kombinationen von Polymeren mit unterschiedlichen Quellungs- bzw. Volumenausdehnungseigenschaften für die Erzeugung der erfindungsgemäßen Mikroröhrchen mittels des Self-Scrolling-Effektes einsetzbar.
Insbesondere vorteilhaft einsetzbar sind Polystyren, Poly(2-Vinylpyridin), Poly(4-Vinylpyridin), Polyisopren, Polybutadien, Polymethacrylat, Polyacrylat, Poly(divinylbenzen), Polydimethylsiloxan, Polyethylenoxid, Polypeptide, Stärke, Cellulose und Polysaccharide.

Eine alternative Lösung der Aufgabenstellung der Erfindung wird nachfolgend angegeben.
Danach wird die Aufgabe der Erfindung auch dadurch gelöst, dass eine Polymerschicht aus nur einem Polymer verwendet wird, wobei die Polymerschicht einen Gradienten in Richtung der Schichtdicke aufweist. Der Gradient betrifft dabei physikalisch-chemische oder chemische Eigenschaften des Polymers, die eine Volumen- und/oder Längenänderung verursachen, beispielsweise durch Quell- oder Schrumpfbarkeit des Polymers. Demnach ist gemäß einer vorteilhaften Ausgestaltung der Erfindung die Quervernetzung des Polymers ein derartiger Parameter, über welchen ein Gradient, als Grad der Vernetztheit, in Richtung der Schichtdicke der Polymerschicht ausgebildet ist. Durch den Grad der Vernetzung verändert sich die Quellbarkeit des Polymers in Richtung der Schichtdicke, welche somit in einer Gradientenschicht, z.B. auf einer Oberfläche der Polymerschicht, stärker ist als auf der anderen. Das erfindungsgemäße Prinzip der Anwendung des Self-Scrolling-Effektes ist somit durch eine unterschiedliche Quervernetzung und darauf basierende Quellbarkeit innerhalb einer einlagigen Polymerschicht realisierbar.

Der Self-Scrolling-Effekt wird weiterhin alternativ dadurch gezielt gesteuert, dass vertikal ein Gradient in der Schichtzusammensetzung ausgebildet wird. Dies wird bevorzugt dadurch erreicht, dass ein Block-Copolymer mit einem Gradienten in der Zusammensetzung der Komponenten verwendet wird, insbesondere durch einen Gradienten in der Konzentration von niedermolekularen Gastmolekülen bzw. Zusatzstoffen im Block-Copolymer.

Ein Gradient der Zusammensetzung kann auch mit einer Polymermischung aus zwei oder mehr Komponenten erreicht werden, wenn die Komponenten sich an der Oberfläche oder dem Substrat anreichern. Unabhängig von dem Gradienten werden auch Polymermischungen aus mehr als einer Komponente mit Polymer und organischem oder anorganischem Zusatzstoff eingesetzt.

Der Self-Scrolling-Effekt wird nach einer weiteren Ausgestaltung der Erfindung auch erreicht, wenn eine chemische Umsetzung einer Komponente der Polymerschicht stattfindet, insbesondere dann, wenn eine Zersetzung einer Komponente mit Gasentwicklung stattfindet oder wenn durch eine Reaktion von Komponenten miteinander unter einer Volumenänderung in der Polymerschicht auftritt. Auch die Zersetzung eines Teils eines einzelnen Films außerhalb der mittleren Lage der Polymerschicht oder an der Oberfläche führt zur erfindungsgemäßen Anwendung des Self-Scrolling-Effektes. Der Effekt wird verstärkt und als Superscrolling bezeichnet, wenn sich eine Lage der Polymerschicht zusammenzieht und eine andere Lage der Polymerschicht sich ausdehnt.

Hierzu werden Materialien wie bei Schrumpfschläuchen verwendet, die sich bei Erwärmung zusammenziehen.
Über die gewünschten Einsatzgebiete der Mikroröhrchen hinaus wird der Effekt bei Röhren mit größerem Durchmesser und größerer Filmdicke z.B. bei Durchmessern zwischen Mikrometer und Zentimeter und Filmdicke zwischen 0,1 Mikrometer und 1 Millimeter, auch zur Verrichtung von Arbeit in Aktuatoren zum Verschließen bzw. Öffnen eines Ventils für Gas oder Flüssigkeit verwendet.

## Patentansprüche

1. Verfahren zur Herstellung von Mikroröhrchen aus Polymermaterialien, bei dem
a) auf einem festen Substrat mit einer ebenen Oberfläche eine erste dünne Schicht eines Polymers aufgebracht wird,
b) wonach mindestens eine zweite Schicht auf der ersten Schicht aufgebracht wird, wonach
c) die mehrlagige Polymerschicht auf dem Substrat in Segmente derart zertrennt wird,
d) dass anschließend ein Lösungsmittel entlang der Außenkanten der Segmente zum Substrat vordringen kann und die mehrlagige Polymerschicht Segmentweise vom Substrat abgelöst wird, wobei
e) das Lösungsmittel aus Verfahrensschritt d) eine Volumenänderung in mindestens einer Schicht hervorruft, so dass
f) die vom Substrat abgelösten Segmente der mehrlagigen Polymerschicht sich zu Mikroröhrchen rollen.

2. Verfahren zur Herstellung von Mikroröhrchen aus Polymermaterialien, bei dem
A) auf einem festen Substrat mit einer ebenen Oberfläche eine Schicht eines Polymers aufgebracht wird,
B) wobei die Polymerschicht einen Gradienten in Richtung der Schichtdicke aufweist und der Gradient eine physikalisch-chemische oder chemische Eigenschaft des Polymers betrifft, die eine Volumenänderung verursachen kann und dass
C) die einlagige Polymerschicht auf dem Substrat in Segmente derart zertrennt wird,
D) dass anschließend Lösungsmittel entlang der Außenkanten der Segmente zum Substrat vordringen kann und die einlagige Polymerschicht Segmentweise vom Substrat abgelöst wird, wobei
E) das Lösungsmittel aus Verfahrensschritt D) in der Polymerschicht zu einer unterschiedlichen Volumenänderung der Gradientenschichten führt, so dass
F) die vom Substrat abgelösten Segmente der einlagigen Polymerschicht sich zu Mikroröhrchen rollen.

3. Verfahren nach Anspruch 1 oder 2, **dadurch gekennzeichnet, dass** vernetzbare Polymere eingesetzt werden die nach Verfahrensschritt a), A) und/oder nach Verfahrensschritt b) vernetzt werden.

4. Verfahren nach einem der Ansprüche 1 bis 3, **dadurch gekennzeichnet, dass** die Polymerlagen in Verfahrensschritt a), A) und/oder b) durch Tauchbeschichtung oder spin-coating aufgebracht werden.

5. Verfahren nach einem der Ansprüche 1 bis 4, **dadurch gekennzeichnet, dass** als Substrate ein Metall, Halbleiter, Glas, Polymere, Fette, Keramik, Biopolymere, Ionenkristalle, absorbierte Schichten von Kohlendioxid, Polymerbündel oder quasi-Flüssigschichten eingesetzt werden.

6. Verfahren nach einem der Ansprüche 1 bis 5, **dadurch gekennzeichnet, dass** auf dem Substrat eine Opferschicht aus Metall oder Oxid aufgebracht wird, welche vom Lösungsmittel in Verfahrensschritt d) aufgelöst wird.

7. Verfahren nach einem der Ansprüche 1 bis 6, **dadurch gekennzeichnet, dass** die Segmente in Verfahrensschritt c) oder C) durch Kratzen, Schneiden, Ritzen oder lithografische Verfahren erzeugt werden.

8. Verfahren nach einem der Ansprüche 1 und 3 bis 7, **dadurch gekennzeichnet, dass** eine 10 µm dicke Aluminiumfolie als Substrat und Opferschicht mit Poly-(4-Vinylpiridin) (P4VP, Molekulargewicht MW=42500 g/mol) mittels Tauchbeschichtung beschichtet wird, wobei das P4VP in einer 5 prozentigen Lösung des Polymers in Chloroform eingesetzt wird, wonach die P4VP Schicht durch eine Quaternisierungsreaktion in gesättigtem Dampf von 1,4-Diiodbutan quervernetzt wird und dass anschließend eine Polystyrene-Schicht (PS, MW=48400 g/mol) über der P4VP-Schicht mittels eines dip-coating-Verfahrens aufgebracht wird, wobei das PS in einer 5 prozentigen Lösung in Toluen angewandt wird und dass mit PS-P4VP Block-Copolymer (MW PS 32900 g/mol; PVP 8080 g/mol) als Bindungsvermittler der Zusammenhalt der Schichten aus P4VP und PS erhöht wird, wobei der Bindungsvermittler der PS-Lösung in einer Menge von 1 %, bezogen auf die Menge PS, zugegeben wird wonach die mehrlagige Polymerschicht in eine einprozentige Salzsäure (HCl) gegeben wird, wodurch sich die PS-Schicht zusammenzieht und als Schutzschicht für die P4VP-Schicht und das Aluminiumsubstrat wirkt und dass mittels Kratztechnik die mehrlagige Polymerschicht zerschnitten wird und dass die P4VP-Schicht unter dem Einfluss der Salzsäurelösung schwillt und sich ausdehnt, wobei die Ausdehnung durch die starre PS-Schicht begrenzt wird, was zu einem ausreichenden Biegemoment und zum Einrollen der mehrlagigen Polymerschicht führt.

9. Verfahren nach einem der Ansprüche 2 bis 7, **dadurch gekennzeichnet, dass** die Polymerschicht mit einem sich ändernden Grad der Quervernetzung des Polymers in Richtung der Schichtdicke der Polymerschicht ausgebildet ist und durch diesen Gradienten die Volumenänderung durch Quellbarkeit des Polymers realisiert wird.

10. Verfahren nach einem der Ansprüche 2 bis 7, **dadurch gekennzeichnet, dass** als Polymerschicht ein Block-Copolymer eingesetzt wird in der vertikal ein Gradient der Schichtzusammensetzung ausgebildet ist, wobei der Gradient durch die Änderung der Konzentration von niedermolekularen Gastmolekülen bzw. Zusatzstoffen im Block-Copolymer erreicht wird.

## Claims

1. Process for the production of microtubes of polymer materials, whereby
a) A first thin layer of a polymer is applied to a solid substrate with a flat surface;
b) After which at least a second layer is applied to the first layer; after which
c) The multi-layer polymer coating is detached from the substrate in segments such that
d) A solvent may penetrate to the substrate along the outer edge of the segments and the multi-layer polymer coating may be detached in segments from the substrate; whereby
e) The solvent from process step d) creates a change in volume in at least one layer, so that
f) The segments of the multi-layer polymer coating detached from the substrate may be rolled into microtubes.

2. Process for the production of microtubes of polymer materials, whereby
A) One layer of a polymer is applied to a solid substrate with a flat surface;
B) whereby the polymer layer exhibits a gradient in the direction of the layer thickness and the gradient relates to a physico-chemical or chemical attribute of the polymer that may cause a change in volume and that
C) The single-layer polymer coating is removed from the substrate in segments such that
D) Solvents may penetrate to the substrate along the outer edge of the segments and the single-layer polymer coating may be removed in segments from the substrate; whereby
E) The solvent from process step D) results in differing changes in volume of the gradient layers within the polymer coating,
F) The segments of the single-layer polymer coating detached from the substrate may be rolled into microtubes.

3. Process in accordance with claim 1 or 2, **characterised in that** linkable polymers are used that are linked via process step a), A) and/or via process step b).

4. Process in accordance with claims 1 to 3, **characterised in that** the polymer layers in process step a), A) and/or b) are applied via dip coating or spin-coating.

5. Process in accordance with claims 1 to 4, **characterised in that** the substrate is comprised of metal, semi-conductor, glass, polymers, fats, ceramics, bio-polymers, ionic crystals, absorbed layers of carbon dioxide, polymer bundles or quasi-liquid layers.

6. Process in accordance with claims 1 to 5, **characterised in that** a sacrificial layer of metal or oxide is applied which is then removed by the solvent in process step d).

7. Process in accordance with claims 1 to 6, **characterised in that** the segments in process step c) or C) are creates by means of scraping, cutting, scoring or lithographic processes.

8. Process in accordance with claims 1 and 3 to 7, **characterised in that** a 10 µm thick layer of aluminium foil is used as the substrate and sacrificial layer with poly (4-Vinylpyridine) ((P4VP, molecular weight MW=42500 g/mol) is coated by means of dip coating, whereby the P4VP is used in a 5% solution of the polymer in chloroform, after which the P4VP layer is cross-linked via a quaternisation reaction in saturated vapour of 1.4 diiodo butane and that thereafter a polystyrene layer (PS, MW=48400 g/mol) is applied on top of the P4VP layer by means of a dip-coating process, whereby the PS is used in a 5% solution of toluene and that the PS-P4VP block copolymer (MW PS 32900 g/mol; PVP 8080 g/mol) is enhanced as the binding agent for the cohesion of the P4VP and PS layers, whereby the binding agent for the PS solution is added in a quantity of 1% in relation to the quantity of PS, after which the multi-layer polymer coating is added to a 1% hydrochloric acid (HCL) which causes the PS layer to contract and functions as a protective layer for the P4VP layer and the aluminium substrate and that the multi-layer polymer coating is cut by means of a scraping method and that the P4VP layer swells and expands under the influence of the hydrochloric acid solution, whereby the expansion is limited by the rigid PS layer which results in a sufficient bending moment to roll the multi-layer polymer coating.

9. Process in accordance with claims 2 to 7, **characterised in that** the polymer coating is formed with a varying degree of cross-linking of the polymer in the direction of the coating thickness and these gradients cause the change in volume by means of the swelling properties of the polymer.

10. Process in accordance with claims 2 to 7, **characterised in that** a block copolymer is used as the polymer coating in which a vertical gradient is formed in the layer composition, whereby the gradient is achieved by means of a change in the concentration of low molecular guest molecules or additives, respectively, in block copolymer.

## Revendications

1. Procédé de fabrication de microtubes en matériaux polymères, selon lequel
a) une première couche mince de polymère est déposée sur un substrat solide doté d'une surface lisse,
b) après quoi au moins une deuxième couche est déposée sur la première, après quoi
c) la couche polymère multiple sur le substrat est divisée en segments,
d) de manière à ce qu'un solvant puisse pénétrer le long des bords extérieurs des segments jusqu'au substrat afin de séparer les segments de la couche polymère multiple du substrat, afin que
e) le solvant mentionné à l'étape d) du procédé provoque une modification du volume dans au moins une couche, de sorte que
f) les segments de la couche polymère multiple détachés du substrat s'enroulent pour former des microtubes.

2. Procédé de fabrication de microtubes en matériaux polymères, selon lequel
A) une couche de polymère est déposée sur un substrat solide doté d'une surface lisse,
B) la couche de polymère présentant alors un gradient dans le sens de l'épaisseur de la couche et ce gradient affectant une propriété physico-chimique ou chimique du polymère susceptible de causer une modification du volume, de sorte que
C) la couche polymère simple sur le substrat est divisée en segments,
D) permettant ainsi à un solvant de pénétrer le long des bords extérieurs des segments jusqu'au substrat pour séparer les segments de la couche polymère simple du substrat,
E) le solvant de l'étape D) du procédé provocant alors dans la couche polymère une modification du volume des couches à gradient, de sorte que
F) les segments de la couche polymère simple détachés du substrat s'enroulent pour former des microtubes.

3. Procédé selon la revendication 1 ou 2, **caractérisé en ce que** des polymères réticulables sont mis en oeuvre selon l'étape de procédé a), A) et/ou l'étape de procédé b).

4. Procédé selon l'une des revendications 1 à 3, **caractérisé en ce que** les couches de polymère sont déposées lors de l'étape de procédé a), A) et/ou b) par trempé ou par rotation.

5. Procédé selon l'une des revendications 1 à 4, **caractérisé en ce que** les substrats utilisés peuvent être de type métal, semi-conducteur, verre, polymère, graisse, céramique, biopolymère, cristal à liaison ionique, couches absorbées de dioxyde de carbone, faisceau polymère ou couches quasi-liquides.

6. Procédé selon l'une des revendications 1 à 5, **caractérisé en ce qu**'une couche sacrificielle de métal ou d'oxyde est déposée sur le substrat, puis dissoute par le dissolvant lors de l'étape de procédé d).

7. Procédé selon l'une des revendications 1 à 6, **caractérisé en ce que** les segments sont créés lors de l'étape de procédé c) ou C) par raclage, découpage, entaillage ou procédé lithographique.

8. Procédé selon l'une des revendications 1 et 3 à 7, **caractérisé en ce qu'**une feuille d'aluminium de 10 µm d'épaisseur est utilisée comme substrat et recouverte d'une couche sacrificielle de poly-(4-vynipyridine) (P4VP, poids moléculaire PM=42500 g/mol) par trempé, le P4VP étant mis en oeuvre dans une solution à 5 % du polymère dans du chloroforme, après quoi la couche de P4VP subit une réticulation transversale par le biais d'une réaction de quaternisation dans une vapeur saturée de 1,4-diiodobutane et une couche de polystyrène (PS, PM=48400 g/mol) est appliquée sur la couche P4VP par rotation, le PS étant appliqué dans une solution à 5 % dans du toluène, le copolymère séquencé de PS-P4VP (PM PS 32900 g/mol ; PVP 8080 g/mol), en tant qu'agent de liaison, améliorant la cohésion des couches de P4VP et de PS, l'agent de liaison de la solution de PS étant ajouté dans une quantité de 1 % par rapport à la quantité de PS, après quoi la couche polymère multiple est appliquée dans une solution d'acide chlorhydrique à 1 % (HCl) à laquelle se rajoute la couche de PS et agit comme une couche protectrice pour la couche de P4VP et pour le substrat d'aluminium, puis la couche polymère multiple est divisée par raclage et, sous l'effet de la solution d'acide chlorhydrique, la couche de P4VP gonfle, l'expansion étant limitée par la couche de PS rigide, ce qui entraîne un moment de flexion suffisant et l'enroulement de la couche polymère multiple.

9. Procédé selon l'une des revendications 2 à 7, **caractérisé en ce que** la couche polymère se forme avec un degré variable de réticulation transversale du polymère dans le sens de l'épaisseur de la couche polymère et que ces gradients entraînent la mise en oeuvre d'une modification du volume grâce à la capacité de gonflement du polymère.

10. Procédé selon l'une des revendications 2 à 7, **caractérisé en ce qu**'un copolymère séquencé est utilisé comme couche polymère, dans lequel un gradient se forme à la verticale, ce gradient étant atteint par la modification de la concentration des molécules hôtes ou des adjuvants de faible poids moléculaire dans le copolymère séquencé.
